# EUROPÄISCHE PATENTSCHRIFT

(11) **EP 3 829 274 B1**
(45) Veröffentlichungstag und Bekanntmachung des Hinweises auf die Patenterteilung: **01.05.2024**
(21) Anmeldenummer: 20209119.5
(22) Anmeldetag: 23.11.2020
(51) Int. Cl.: H05K 3/46, H05K 1/18, H05K 3/10, H05K 3/00

(54) **VERFAHREN ZUR FERTIGUNG ELEKTRONISCHER BAUTEILE**
METHOD FOR THE PRODUCTION OF ELECTRONIC COMPONENTS
PROCÉDÉ DE FABRICATION DE COMPOSANTS ÉLECTRONIQUES

(30) Priorität: 27.11.2019 DE 102019218378; 06.08.2020 DE 102020209965
(43) Veröffentlichungstag der Anmeldung: 02.06.2021
(73) Patentinhaber: Robert Bosch GmbH, 70442 Stuttgart (DE)
(72) Erfinder: Schmidt, Kaja, 70195 Stuttgart (DE); Metry, Marina Sameh Adly, 70569 Stuttgart (DE); Wahl, Ruben, 71394 Kernen Im Remstal (DE)

(56) Entgegenhaltungen:
- WO-A2-02/20251
- US-A1- 2007 286 946

## Beschreibung

### Technisches Gebiet

Die Erfindung bezieht sich auf ein Verfahren zur Herstellung elektronischer Bauteile mit elektronischen und/oder nicht-elektronischen Komponenten, die in einem zeitgleich additiv aus 2D-Strukturen in Z-Richtung aufgebauten Gehäuse integriert werden, und eine Verwendung des Verfahrens zur Herstellung elektronischer Bauteile.

### Stand der Technik

Additive Fertigungsverfahren (additive manufacturing) umfassen ein breites Spektrum von Technologien, die prinzipiell Volumenelemente miteinander verbinden. In der Regel erfolgt dies über einen schichtweisen Aufbau. Dies bedeutet, dass das dreidimensionale Modell des Bauteils in zweidimensionale ebene Flächen aufgeteilt wird und ein digitaler Pfad definiert wird. Eine Fertigungseinheit fährt den definierten digitalen Pfad ab und hinterlässt verfahrensabhängig verarbeitetes Material, welches so Schicht für Schicht zu einem dreidimensionalen Objekt anwächst. Ein derartiges Vorgehen führt dazu, dass im Vergleich zu subtraktiven Fertigungsprozessen mit nahezu unbegrenzter geometrischer Flexibilität gearbeitet werden kann.

Es wurde ein erheblicher Aufwand dahingehend betrieben, um etablierte AM-Verfahren weiter zu entwickeln und neue Prozesse zu erschließen, so dass eine bisherige Bezeichnung "Rapid Prototyping Technology" überholt erscheint. Im Bereich kunststoffbasierten 3D-Drucks wurden neue Materialsysteme und Prozessvarianten eingeführt.

Es werden nicht nur die Prozesse weiterentwickelt, auch die Komplexität der generierten Bauteile nimmt stetig zu. Themen wie Funktionsintegration und Multimaterialanwendungen spielen eine zentrale Rolle. Im Bereich elektrischer Funktionalisierung von additiv gefertigten Bauteilen gibt es viele Forschungsprojekte. Die Kombination aus elektrisch funktionalen Materialien mit additiver Fertigung, ergänzt durch Pick-and-Place-Anwendungen, erlaubt die Herstellung von Bauteilen, die mit herkömmlichen Verfahren nicht möglich sind, so zum Beispiel mehrschichtige Leiterplatten, elektrische Steckverbinder, 3D-Antennen missionsspezifischer Satellitenkomponenten, 3D-Strukturen mit integrierter Elektronik und Batterien.

Die Integration elektrischer Funktionalitäten in bisherige Fertigungsprozesse ist jedoch mit einigen Nachteilen behaftet. So sind im Rahmen von Fertigungsprozessen, wie beispielsweise Vat-Polymerization, Sheet Lamination, Binder Jetting und Powder Bed Fusion, allesamt die Voraussetzungen dahingehend gerichtet, dass das Material einer 2D-Schicht immer in gleicher geometrischer Form vorzuliegen hat. Die beabsichtigte geometrische Form dieser 2D-Schicht wird dann durch selektives Härten, Verkleben oder Ausschneiden erreicht, so dass in der Folge Bereiche entstehen, die der finalen Geometrie angehören sowie Bereiche, die nach dem Druck entfernt werden müssen. Auf diese Art und Weise sind Hohlräume, die zum Beispiel als Kavitäten für integrierte Leiterplatten oder SMD-Bauteile dienen, darstellbar, jedoch sind diese im Prozess mit immer noch flüssigem, pulverförmigem oder festem Material gefüllt. Um die oben genannten Komponenten integrieren zu können, ist daher erst eine relativ aufwändige Reinigung erforderlich. Eine Integration im laufenden Druckprozess wurde bisher noch nicht umgesetzt.

Verfahren, die nach dem Prinzip arbeiten, Bauteile durch das schichtweise Auftragen von Material zu erzeugen, ermöglichen demgegenüber eine Integration elektrischer Funktionen im laufenden Druckprozess, da erzeugte Kavitäten nicht gereinigt werden müssen. Ein gängiges Verfahren im Bereich der Thermoplastverarbeitung ist dabei der Prozess FFF oder FDM. Die Abkürzung FFF steht für Fused Filament Fabrication; die Abkürzung FDM bezeichnet Fused Deposition Modelling.

Im Hinblick auf die Integration elektrischer Funktionalitäten in das additiv gefertigte Bauteil ergeben sich folgende Nachteile:
Es ist eine reduzierte räumliche Auflösung gegeben, ferner sind die Oberflächen im Allgemeinen uneben, was zu Schwierigkeiten beim Leiterbahndruck führen kann. Es entsteht ein relativ hoher Leistungsverlust in Aufbaurichtung, d. h. im Wesentlichen in Z-Richtung aufgrund anisotroper mechanischer Eigenschaften. Ferner herrschen relativ hohe Verarbeitungstemperaturen. Im Vergleich zur Verarbeitung von duroplastischen Materialien ist eine höhere Wasseraufnahme gegeben. Insbesondere bei Multimaterialanwendungen, beispielsweise in Verbindung mit elektrischen Komponenten und Leiterplatten, entsteht ein relativ hoher Ausdehnungskoeffizient, ferner ist es relativ schwierig, Supportstrukturen zu entfernen.

Dies bedeutet, dass bestimmte Prozesse, so zum Beispiel Materialprozesskombinationen, Einschränkungen im Hinblick auf die Integration elektrischer Funktionalitäten prozessimmanent mit sich bringen.

Entsprechende Verfahren nach dem Stand der Technik sind in US 2007/286946 A1 und WO 02/20251 A2 offenbart.

### Darstellung der Erfindung

Erfindungsgemäß wird ein Verfahren vorgeschlagen zur Fertigung elektronischer Bauteile mit elektronischen oder nicht-elektronischen Komponenten, die in einem zeitgleich additiv aus 2D-Strukturen in Z-Richtung aufgebauten Gehäuse integriert werden, wobei nachfolgende Verfahrensschritte durchlaufen werden:
a) Druck einer Außenkontur einer 2D-Struktur,
b) Vernetzung der Außenkontur der 2D-Struktur,
c) mittels einer UV-Lichtquelle,
d) Auffüllung der Außenkontur derart, dass Einzelschichten in gewünschter Geometrie mit Freisparungen für mindestens eine Kavität erzeugt werden,
e) erneute Vernetzung der verfüllten geschlossenen 2D-Struktur mittels der UV-Lichtquelle,
f) Erzeugung eines Stapelaufbaus durch Wiederholung der Schritte a) bis e),
g) Einfüllen von Klebstoff in die mindestens eine Kavität in einer definierten Menge,
h₁) Platzierung mindestens einer elektronischen oder nicht-elektronischen Komponente in mindestens eine Kavität und Erzeugung einer geschlossenen Einzelschicht mit eingebetteter Komponente, oder
h₂) Erzeugen von 2D-Leiterbahnstrukturen oder 3D-Leiterbahnstrukturen in Kavitäten, insbesondere Kanälen oder auf Freiflächen durch Dispensen eines Leitklebstoffs in die als Kanäle ausgeführten Kavitäten oder auf die Freiflächen,
i) erneute Vernetzung der geschlossenen 2D-Struktur,
j) Wiederholung der Verfahrensschritte a) bis e) solange, bis ein vollständiger Stapelaufbau in Z-Richtung aufgebaut ist und
k) Aushärtung des erhaltenen Stapelaufbaus des elektronischen Bauteils aus 2D-Strukturen in Z-Richtung durch Wärme.

In Weiterbildung des erfindungsgemäß vorgeschlagenen Verfahrens wird in den Verfahrensschritten a) und g) ein bei Raumtemperatur verarbeitbares höher viskoses Material zur Herstellung der 2D-Strukturen eingesetzt.

In vorteilhafter Weise werden im Rahmen der Verfahrensschritte a), d) und g) kationisch polymerisierende 1K-Epoxide in Kombination mit extern stimulierbaren Initiatorsystemen eingesetzt.

Beim erfindungsgemäß vorgeschlagenen Verfahren umfasst die Gruppe kationisch polymerisierender 1K-Epoxide folgende Materialien: Diglycidyletherderivate von Bisphenol A (DGEBA), 3,4-Epoxycyclohexylmethyl-3,4-epoxycyclohexancarboxylat (ECC) sowie Epoxide aliphatischer Alkohole, wie beispielsweise Trimethyloylpropan.

Beim erfindungsgemäß vorgeschlagenen Verfahren kommen als extern stimulierbare Initiatorsysteme beispielsweise zu eisenbasierter Lewissäure zerfallende Ferroceniumsalze in Betracht.

In Weiterbildung des erfindungsgemäß vorgeschlagenen Verfahrens wird als Aufbaumaterial bevorzugt ein epoxidbasiertes Material eingesetzt.

Beim erfindungsgemäß vorgeschlagenen Verfahren erfolgt eine Vernetzung über die UV-Lichtquelle beim schichtweisen Auftrag der 2D-Struktur nach der Auffüllung. Dies führt in vorteilhafter Weise zu einer Stabilisierung des Bauteiles und ermöglicht komplexe Geometrien, und erlaubt es insbesondere auch, Überhänge zu realisieren.

Eine weitere abschließende Vernetzung der 2D-Strukturen erfolgt innerhalb des Stapelaufbaus auf thermischem Wege. Die thermische Vernetzung hat zur Folge, dass die zuvor geometrisch stabilen Schichten untereinander chemisch vernetzen und damit in Z-Richtung eine höhere Festigkeit erreicht werden kann im Vergleich zu Festigkeiten, die mit den eingangs erwähnten FFF/FDM-Verfahren erreicht werden können.

Durch die duale Härtung, d. h. die Vernetzung oder die finale Vernetzung auf thermischem Wege werden chemische Reaktionen zwischen den 2D-Strukturen initiiert, die die Festigkeit des Stapelaufbaus insbesondere in Z-Richtung in vorteilhafter Weise beeinflussen.

Beim erfindungsgemäß vorgeschlagenen Verfahren können im Rahmen der dualen Härtung mit Vernetzung und finaler Vernetzung Klebeprozesse in Bereichen erfolgen, die außerhalb des Strahlungsbereichs der UV-Lichtquelle liegen.

In Weiterbildung des erfindungsgemäß vorgeschlagenen Verfahrens lassen sich in vorteilhafter Weise Schichthöhen ab 0,08 mm realisieren. Die maximal erreichbare Schichthöhe ist davon abhängig, wie tief eine Vorvernetzung durch das UV-Licht ausgefallen ist.

In Weiterbildung des erfindungsgemäß vorgeschlagenen Verfahrens werden bei Ausführung des Verfahrensschritts h₂), dem Erzeugen von zweidimensionalen Leiterbahnstrukturen oder dem Erzeugen von dreidimensionalen Leiterbahnstrukturen diese mittels eines in horizontale und in vertikale Richtung verfahrbaren Dispensers erzeugt, der in die als Kanäle ausgeführten Kavitäten eintaucht. Dadurch kann auf dem Boden der Kavitäten ein Volumen, beispielsweise eines Leitklebstoffs dispenst werden. Zweidimensionale Leiterbahnen können erzeugt werden, indem zweidimensionale Kavitäten aufgefüllt werden, aber auch auf einer freien Fläche ohne Kavität. In diesem Fall appliziert die Dispensernadel einen Leitklebstoff in der jeweils gewünschten geometrischen Anordnung.

In Weiterbildung des erfindungsgemäß vorgeschlagenen Verfahrens gemäß Verfahrensschritt h₂) fährt der Dispenser beziehungsweise eine Dispensernadel innerhalb der als Kanal ausgeführten Kavität entsprechend einer Kanalhöhe wiederholt in diese ein und dispenst ein Volumen von Leitklebstoff in einem oder in mehreren Schritten. Demnach erfolgt auch gemäß Verfahrensschritt h₂) ein Aufbau einer 3D-Leiterbahnstruktur innerhalb eines eine Kanalhöhe aufweisenden Vertikalkanals.

Die Erfindung bezieht sich darüber hinaus auf die Verwendung des Verfahrens zur Fertigung von vollständigen elektronischen Bauteilen mit integrierten elektrischen Funktionalitäten, insbesondere mehrschichtig ausgeführte Leiterplatten, elektrische Steckverbinder, 3D-Antennen, missionsspezifische Satellitenkomponenten, 3D-Strukturen mit integrierter Elektronik, Batterien, bauteilintegrierte 2D-Leiterbahnstrukturen oder bauteilintegrierte 3D-Leiterbahnstrukturen.

### Vorteile der Erfindung

Durch das erfindungsgemäß vorgeschlagene Verfahren kann ein sehr breites Spektrum duroplastischer Materialsysteme zum Einsatz gelangen. Epoxide sind besonders hervorzuheben, da diese die am besten geeignete Gruppe an Monomeren für die additive Fertigung darstellen. Grundsätzlich können Materialsysteme extrusionsbasierter Verfahren im 3D-Aufbau zum Einsatz kommen. Durch das erfindungsgemäß vorgeschlagene Verfahren lässt sich hinsichtlich des Aufbauprozesses eine Einbettung und Kontaktierung elektrischer Komponenten während des additiven Aufbauprozesses des Gehäuses in 2D-Schichtbauweise erreichen. Ein aufwändiges Reinigen beziehungsweise Herausnehmen aus dem Fertigungsbereich, wie dies bei Verfahren mit einem Materialbett erforderlich ist, kann entfallen. Hinsichtlich des Einsatzes geeigneter Materialien können beim erfindungsgemäß vorgeschlagenen Verfahren geeignete Materialsysteme in Kombination mit den SMD-Komponenten und damit einhergehender Einsatzgebiete Verwendung finden. Es lässt sich eine verbesserte Temperaturbeständigkeit hinsichtlich ähnlicher Wärmeausdehnungskoeffizienten der eingesetzten Materialien darstellen, eine Feuchtigkeitsbeständigkeit hinsichtlich einer Wasseraufnahme der Materialien ist im Vergleich zu Verfahren aus dem Stand der Technik erheblich verbessert, ferner lässt sich eine verbesserte Verarbeitbarkeit hinsichtlich der Dosierbarkeit der Materialien sowie auftretender Schrumpferscheinungen realisieren. Im Vergleich zu bisher gängigen Verfahren sind eine verbesserte Medienbeständigkeit zu konstatieren sowie ein wesentlich geringeres Korrosionspotential. Die Haftung der Komponenten auf metallischen Materialien und Kunststoffen ist erheblich verbessert, ebenso wie die Festigkeit auch bei einem erhöhten Umgebungstemperaturniveau.

Beim erfindungsgemäß vorgeschlagenen Verfahren können hinsichtlich der Elektronikintegration folgende Verbesserungen erreicht werden:
Die Einbettung der Komponenten sowie deren Verbindung innerhalb des Gehäuses und aus dem Gehäuse heraus erfolgt wesentlich zuverlässiger und schonender, in der Regel möglichst über Form- und Stoffschluss. Ein verschleißfördernder Kraftschluss kann vermieden werden. Die dafür eingesetzten Materialien sind in bevorzugter Weise mit dem Werkstoff, aus dem das Gehäuse gefertigt wird, kombinierbar; die eingesetzten Materialien können auch aus dem gleichen Material wie das Gehäuse gefertigt sein.

Beim erfindungsgemäß vorgeschlagenen Verfahren kann die Verwendung von Stützmaterial vermieden werden, um einer Beschädigung des Gehäuses und der elektrischen beziehungsweise elektronischen Komponenten vorzubeugen. Leichte Überhänge können realisiert werden, weil die einzelnen Materialschichten durch UV-Licht vorvernetzt und damit stabilisiert sind. Hinterschnitte können beispielsweise durch Verklebung von zwei gedruckten Komponenten miteinander erfolgen. Das Material für die Verklebung ist das gleiche wie das der beiden Gehäuseteile und kann sich somit mit diesen chemisch verbinden.

Beim erfindungsgemäß vorgeschlagenen Verfahren können beispielsweise zur Bestückung von im Stapelaufbau ausgebildeten Kavitäten mit elektronischen oder nicht-elektronischen Komponenten beispielsweise Pick-and-Place-Einrichtungen, so zum Beispiel individualisierbare Sauger an Universalvakuumsauggeräten eingesetzt werden.

Durch das erfindungsgemäß vorgeschlagene Verfahren lässt sich ein verbesserter Materialmix erreichen, da durch die Prozessführung problemlos mehrere Materialien verarbeitet werden können, für den Fall, dass an der Fertigungseinheit mehrere Dosierköpfe eingesetzt werden. Werden insbesondere epoxidbasierte Systeme als Aufbaumaterialien eingesetzt, wird - zumindest aus chemischer Sicht - ein einheitliches System aufgebaut, was vorteilhaft hinsichtlich der sich ausbildenden Vernetzung sowie langfristige Eigenschaften, so zum Beispiel eine Zuverlässigkeit über Lebensdauer, ist.

Des Weiteren lässt sich eine duale Härtung erreichen, welche sowohl durch die UV-Lichtquelle also auch durch Wärme gegeben ist, und die identische chemische Reaktionen hervorruft. Die UV-Lichtquelle kann beispielsweise beim schichtweisen Aushärten der 2D-Strukturen einer Vorvernetzung erfolgen. Eine thermische Nachvernetzung, beispielsweise eine finale Vernetzung, führt zum finalen Aushärten des vollständigen elektronischen Bauteils aus dem Stapelaufbau. Chemische Reaktionen können bei der finalen Vernetzung im Stapelaufbau zwischen den einzelnen 2D-Strukturen ablaufen, was zu einer erhöhten Festigkeit in Z-Richtung führt und somit geringere Anisotropie im Vergleich zu Thermoplasten bietet.

Durch die duale Härtung wird weiterhin in vorteilhafter Weise ermöglicht, dass klassische Klebeprozesse in Schattenzonen, d. h. außerhalb des Strahlungsbereichs der UV-Lichtquelle ablaufen können, die abschließend durch die Warmhärtung, d. h. die finale Vernetzung mit dem Rest des gedruckten additiv aufgebauten Gehäuses verbunden werden können. Dies ermöglicht beispielsweise eine Einbettung von Komponenten oder ein Zusammenfügen unabhängig voneinander gedruckter Teile, so dass Hinterschnitte vermieden werden können.

Bei den verarbeiteten Materialien handelt es sich um eine Materialklasse, die bereits gängig im Bereich der Klebetechnik und beim elektronischen Packaging eingesetzt wird. Die verbesserten Klebeigenschaften können dazu genutzt werden, verschiedene gedruckte Körper mit dem gleichen Materialtyp zu kombinieren oder Komponenten zu fixieren. Darüber hinaus ermöglicht das Material in Kombination mit dem Prozess, auch hochgefüllte Systeme zu verarbeiten, was sich wiederum positiv auf beispielsweise mechanische Eigenschaften auswirkt.

Bei additiven Fertigungsverfahren kommen Leitklebstoffe zum Einsatz, um diese mit Leiterbahnen zu ergänzen. Das erfindungsgemäß vorgeschlagene Verfahren erlaubt die Integration von Komponenten jeglicher Art, nicht nur von elektronischen Komponenten. Durch die eingesetzten Werkstoffe wird eine gleichzeitig stoff- und formschlüssige Verbindung erzielt. Dazu weisen die zur Integration elektrischer Komponenten eingesetzten Materialien vorteilhafte Materialeigenschaften auf. Die Materialien werden teilweise für die Verklebung elektrischer Komponenten eingesetzt und eignen sich somit auch für die vorgesehenen Anwendungen. In der additiven Fertigung werden dreidimensionale Leiterbahnen in der Regel mit duroplastischen Leitklebstoffen hergestellt. Mit dem erfindungsgemäß vorgeschlagenen Verfahren wird somit für ein Aufbau- und Leitmaterial die gleiche chemische Basis verwendet. Dadurch ergeben sich Vorteile in Hinblick auf die Materialanwendungen, so zum Beispiel chemische Verträglichkeit sowie angepasste Eigenschaften. Im vorliegenden Zusammenhang umfasst die Integration von Komponenten auch eine Leiterbahnintegration in herzustellende elektrische oder elektronische Bauelemente.

### Kurze Beschreibung der Zeichnungen

Ausführungsformen der Erfindung werden anhand der Zeichnungen und der nachfolgenden Beschreibung näher erläutert.

Es zeigen:
- Figur 1: eine Funktionseinheit zur Realisierung des erfindungsgemäß vorgeschlagenen Verfahrens,
- Figuren 2.1 bis 2.6: einzelne Teilschritte hinsichtlich der Herstellung von 2D-Strukturen mit Schritten zur Vernetzung und Stapelaufbau,
- Figuren 3.1 bis 3.5: eine Integration von elektronischen oder nicht-elektronischen Komponenten in den additiven Aufbauprozess eines diese umschließenden Gehäuses,
- Figuren 4.1 bis 4.5: ein Erzeugen eines Hohlraums ohne eine Stützstruktur aus geschichtet aufgebauten 2D-Strukturen mit Vernetzung und finalem Vernetzungsschritt,
- Figur 5: einen Schichtaufbau mit einer eingebetteten 2D-Leiterbahnstruktur,
- Figuren 5.1 bis 5.3: eine erste Vorgehensweise zum Aufbau der 2D-Leiterbahnstruktur,
- Figuren 5.4 bis 5.6: eine weitere Vorgehensweise zum Aufbau der 2D-Leiterbahnstruktur,
- Figur 6: einen Schichtaufbau mit einer in diesen eingebetteten 3D-Leiterbahnstruktur,
- Figuren 6.1 bis 6.4: eine erste Vorgehensweise zum Aufbau der 3D-Leiterbahnstruktur und
- Figuren 6.5 bis 6.7: eine weitere Vorgehensweise zum Aufbau der 3D-Leiterbahnstruktur.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

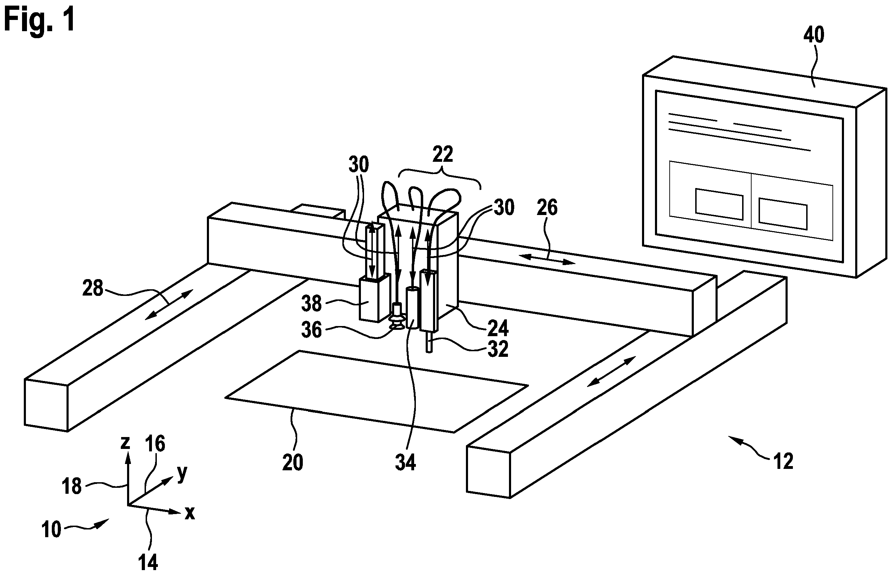

Figur 1 zeigt in schematischer Weise die Fertigungseinheit 12 sowie ein Koordinatensystem 10 in X-, Y- und Z- Richtung Das Koordinatensystem 10 umfasst eine X-Achse 14, eine Y-Achse 16 sowie eine Z-Achse 18. In der Fertigungseinheit 12 wird ein im Wesentlichen zweidimensionales Substrat 20 eingesetzt. Auf das Substrat 20 werden die einzelnen Schichten aufgetragen, die anschließend miteinander vernetzen. Zum Auftrag dient ein Werkzeugkopf 22, der an einem entlang der X-Achse 14 verfahrbaren Schlitten 24 aufgenommen ist. Eine X-Richtung ist mit Bezugszeichen 26, die Y-Richtung mit Bezugszeichen 28 und die senkrecht zu diesen orientierte Z-Richtung mit Bezugszeichen 30 identifiziert.

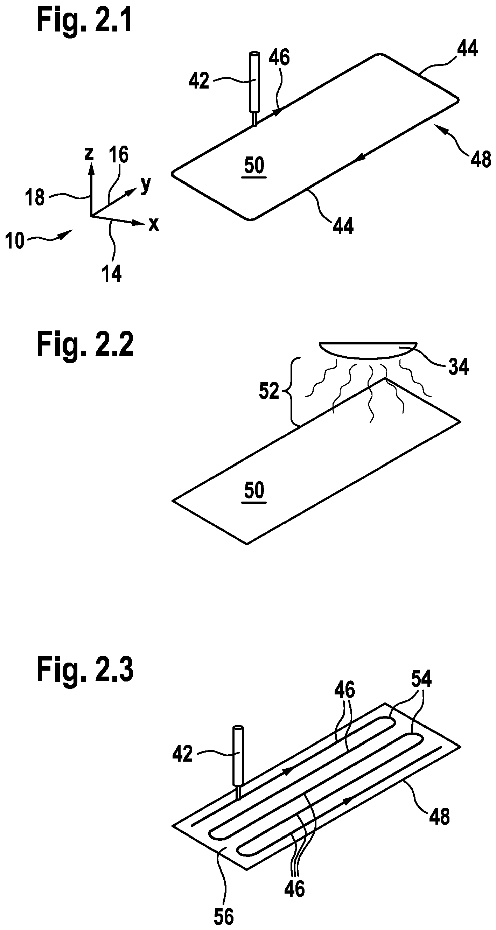

Am Werkzeugkopf 22 der Fertigungseinheit 12 befindet sich mindestens ein Materialkopf 32, der zur Zufuhr des Aufbaumaterials 94 dient, bei dem es sich vorzugsweise um ein epoxidbasiertes Materialsystem handelt. Am Werkzeugkopf 22 ist mindestens eine UV-Lichtquelle 34 vorgesehen sowie ein Pick-and-Place-Operationen vornehmender Vakuumgreifer 36. Zum Zweck von Qualitätskontrollmaßnahmen ist am Werkzeugkopf 22 darüber hinaus mindestens ein Kamerasystem 38 aufgenommen. Die Fertigungseinheit 12, die in der Darstellung gemäß Figur 1 lediglich schematisch dargestellt ist, wird über eine Steuerungseinheit 40 gesteuert. In der Figurensequenz der Figuren 2.1 bis 2.6 sind verschiedene Prozessschritte dargestellt, die beim erfindungsgemäß vorgeschlagenen Verfahren durchlaufen werden. Figur 2.1 zeigt, dass durch eine nadelförmige Applikationsvorrichtung 42, die beispielsweise nadelförmig ausgebildet sein kann, ein Aufbaumaterial 94, beispielsweise ein Epoxidharz oder dergleichen, als Außenkontur 48 verlegt wird. Die nadelförmige Applikationsvorrichtung 42 folgt einem definierten Pfad 44 in einer Abfahrrichtung 46. Dadurch wird eine 2D-Struktur 50 geschaffen, die durch die Außenkontur 48 gegeben ist. Zur Orientierung ist in Figur 2.1 nochmals das Koordinatensystem 10 dargestellt, aus welchem hervorgeht, dass die 2D-Struktur 50 gemäß der Darstellung in Figur 2.1 innerhalb der X-Y-Ebene verläuft.

Figur 2.2 zeigt, dass die in Figur 2.1 dargestellte Außenkontur 48 der offenen 2D-Struktur 50 durch mindestens eine UV-Lichtquelle 34 eine Vernetzung 52 erfährt. Dadurch wird die 2D-Struktur 50 beziehungsweise das Epoxid-basierte Materialsystem teilweise gehärtet und weist eine höhere Stabilität auf.

Im nachfolgenden Schritt, der in der Darstellung gemäß Figur 2.3 wiedergegeben ist, erfolgt eine Auffüllung 54 der noch offenen 2D-Struktur 50 gemäß Figur 2.2, die dort nur durch die Außenkontur 48 definiert ist. Wie aus Figur 2.3 hervorgeht, fährt das nadelförmige Applikationsvorrichtung 42 entlang der Abfahrrichtung 46 und füllt die innenliegenden Bereiche der Außenkontur 48 auf, so dass die in Figur 2.3 dargestellte geschlossene beziehungsweise verfüllte 2D-Struktur 56 entsteht. Das Auffüllen kann mit verschiedenen Füllstrukturen erfolgen. Diese wiederum wird in einem weiteren Schritt einer Vernetzung 52 unterzogen, was über mindestens eine UV-Lichtquelle 34 erfolgt.

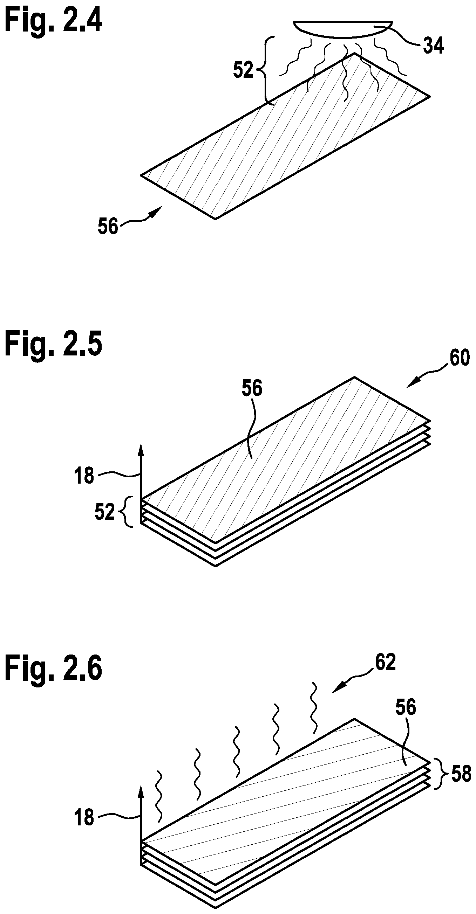

Figur 2.5 zeigt, dass in dieser Darstellung mehrere als Einzelschichten 80 dienende verfüllte beziehungsweise geschlossene 2D-Strukturen 56 entlang der Z-Achse 18, d. h. in Z-Richtung 30 in gestapelter Form übereinanderliegend einen Stapelaufbau 58 darstellen. Der Stapelaufbau 58 stellt beispielsweise einen Teil eines Gehäuses 60 eines vollständigen elektronischen Bauteils 64 dar.

Im Gegensatz zu den Vernetzungen 52, wie sie in Figur 2.2 und 2.4 dargestellt sind, erfolgt eine finale Vernetzung 62 gemäß der Darstellung in Figur 2.6 auf thermischem Wege.

Nach dem erfindungsgemäß vorgeschlagenen Verfahren werden im Wesentlichen die nachfolgenden Verfahrensschritte durchlaufen:
a) Druck einer Außenkontur 48 einer 2D-Struktur 50,
b) Vernetzung 52 der Außenkontur 48 der 2D-Struktur 50,
c) mittels einer UV-Lichtquelle 34,
d) Auffüllung 54 der Außenkontur 48 derart, dass Einzelschichten 80 in gewünschter Geometrie mit Freisparungen für mindestens eine Kavität 70, 72, 100, 114 erzeugt werden,
e) Erneute Vernetzung 52 der verfüllten 2D-Struktur 56 mittels der UV-Lichtquelle 34,
f) Erzeugung eines Stapelaufbaus 58 durch Wiederholung der Schritte a) bis e),
g) Einfüllen von Klebstoff in die mindestens eine Kavität 70, 72, 100, 114 in einer definierten Menge,
h₁) Platzierung mindestens einer elektronischen oder nicht-elektronischen Komponente 74 in die mindestens eine Kavität 70, 72 und Erzeugung einer geschlossenen Einzelschicht 80 mit eingebetteter Komponente 74, oder
h₂) Erzeugen von 2D-Leiterbahnstrukturen 88 oder 3D-Leiterbahnstrukturen 106 in Kavitäten 100, 114, insbesondere Kanälen oder auch Freiflächen 92 durch Dispensen eines Leitklebstoffes 102 in die als Kanäle ausgeführten Kavitäten 100, 114 oder auf die Freiflächen 92,
i) Erneute Vernetzung 52 der geschlossenen 2D-Struktur 56,
j) Wiederholung der Verfahrensschritte a) bis e) solange, bis ein vollständiger Stapelaufbau 58 in Z-Richtung 30 aufgebaut ist und
k) Aushärtung des erhaltenen Stapelaufbaus 58 des vollständigen elektronischen Bauteils 64 aus 2D-Strukturen 50 in Z-Richtung 30.

Beim erfindungsgemäß vorgeschlagenen Verfahren werden Aspekte miteinander kombiniert, um eine additive Fertigung eingebetteter, eingehauster elektrischer und nicht-elektrischer Bauteile 64 zu ermöglichen. Es wird eine 3D-Extrusion eines höher viskosen Materials eingesetzt, welches bei Raumtemperatur verarbeitet werden kann. Das Aufbauprinzip erfolgt durch extrusionsbasierte additive Verfahren (FDM 3DD, DW), d. h. als schichtweises Auftragen des Materials, so dass die gewünschte dreidimensionale Geometrie in Z-Richtung 30 durch schichtweisen Aufbau des Stapelaufbaus 58 erzielt werden kann.

Es werden Materialklassen eingesetzt, insbesondere kationisch polymerisierende 1K-Epoxide in Kombination mit einem extern stimulierbaren Initiatorsystem. Bei den kationisch polymerisierenden 1K-Epoxiden kann es sich beispielsweise um die Glycidyletherderivate von Bisphenol A (DGEBA), 3,4-Epoxycyclohexylmethyl-3,4-epoxycyclohexancarboxylate (ECC) oder Epoxide basierend auf aliphatischen Alkoholen, wie beispielsweise Trimethyloylpropan handeln.

Als Initiatorsysteme, die bevorzugt eingesetzt werden, kommen Ferroceniumsalze zum Einsatz, die zu eisenbasierter Lewissäure zerfallen, was mit einem Verlust des Aren-Liganden einhergeht. Die Koordination der letztgenannten Spezies mit einem Epoxidmonomer erfolgt im Anschluss an eine Ringöffnungspolymerisation.

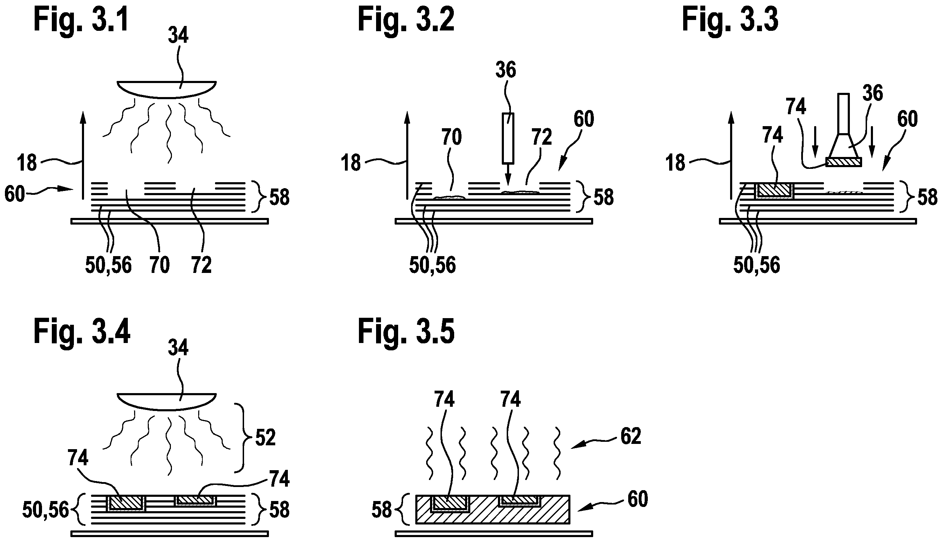

Beim erfindungsgemäß vorgeschlagenen Verfahren kann zur Bestückung der einzelnen Kavitäten 70, 72, wie sie in den Figuren 3 bis 5 noch eingehender beschrieben werden, auf einen Pick-and-Place-Prozess zurückgegriffen werden, der beispielsweise bei Bestückungsautomaten für Leiterplatten gang und gäbe ist. Die in Figur 1 dargestellte Fertigungseinheit 12 umfasst zu diesem Zweck mindestens einen Vakuumgreifer 36, über welchen elektronische oder nicht-elektronische Komponenten 74 (vgl. auch Figuren 3.1 bis 3.5) in entsprechende Kavitäten 70, 72 innerhalb eines Stapelaufbaus 58 platziert werden können. Die Figuren 3.1 bis 3.5 zeigen eine Integration von Komponenten 74 im laufenden Fertigungsprozess.

Figur 3.1 zeigt, dass ein erstes geschichtetes Objekt 78 aus Einzelschichten 80, die offene 2D-Strukturen 50 oder verfüllte 2D-Strukturen 56 sein können, in Richtung der Z-Achse 18 aufgebaut wird. Entsprechend der Konfiguration der Einzelschichten 80 entsteht ein Stapelaufbau 58, der eine erste Kavität 70 beziehungsweise eine zweite Kavität 72 umfasst. Jede einzelne der Einzelschichten 80 wird separat, bevor die darüberliegende Schicht aufgebaut wird, über die mindestens eine UV-Lichtquelle 34 einer Vernetzung 52 unterzogen.

Figur 3.2 ist zu entnehmen, dass die Böden der beiden Kavitäten 70 beziehungsweise 72 der in Figur 1 dargestellten Fertigungseinheit 12 mit einem Klebstoff oder einem Verbindungsmaterial ausgekleidet werden. Böden der ersten und zweiten Kavitäten 70, 72 werden mit Klebstoff aufgefüllt, der dem Gehäuseklebstoff entspricht. Somit kann dieser einfach mittels der Dosiereinheit aufgetragen werden. Der Stapelaufbau 58 umfasst die übereinanderliegend angeordneten 2D-Strukturen 50 beziehungsweise 56. Bei der Applikation des Materials gemäß Figur 3.2 erfolgt keine Vernetzung 52.

Figur 3.3 zeigt, dass in die zuvor mit einem Klebstoff beziehungsweise Verbindungsmaterial ausgekleideten Kavitäten 70 beziehungsweise 72 elektronische oder nicht-elektronische Komponenten 74 eingelassen werden. Dazu dient wieder der auf dem Wege eines Pick-and-Place-Verfahrens eingesetzte mindestens eine Vakuumgreifer 36 im Werkzeugkopf 22 des verfahrbaren Schlittens 24. Die Größe der beiden Kavitäten 70 beziehungsweise 72 ist abhängig von der Anzahl der 2D-Strukturen 50, 56, die innerhalb des Stapelaufbaus 58 aufeinandergeschichtet sind. Beim Einfügen der Komponente 74 in die jeweilige Kavität 70, 72 wird der eingefüllte Klebstoff nach oben gedrückt. Die Klebstoffmenge ist dabei so dimensioniert, dass der Klebstoff nach Einfügen der Komponente 74 genau bis an die Oberkante von Komponente 74 und jeweiliger Kavität 70, 72 reicht.

Figur 3.4 zeigt, dass nach der Platzierung der elektronischen oder nicht-elektronischen Komponenten 74 in den Kavitäten 70, 72 von der Oberseite des Stapelaufbaus 58 her eine Vernetzung 52 durch Aktivierung der mindestens einen UV-Lichtquelle 34 erfolgt.

Figur 3.5 schließlich zeigt, dass als abschließender Behandlungsschritt eine finale Vernetzung 62 durchgeführt wird, in der das Gehäuse 60, d. h. der nunmehr vollendete Stapelaufbau 58 einer thermisch induzierten finalen Vernetzung 62 zugeführt wird, so dass schlussendlich das in Figur 3.4 dargestellte, komplettierte, vollständige elektronische Bauteil 64 fertiggestellt ist. Dadurch, dass für die Einbettung und den Gehäuseaufbau das gleiche Material eingesetzt wird, kommt es zu einer idealen Verbindung der eingebetteten Komponenten 74 durch chemische Vernetzung 76 zwischen Gehäuseschichten und Material zur Einbettung.

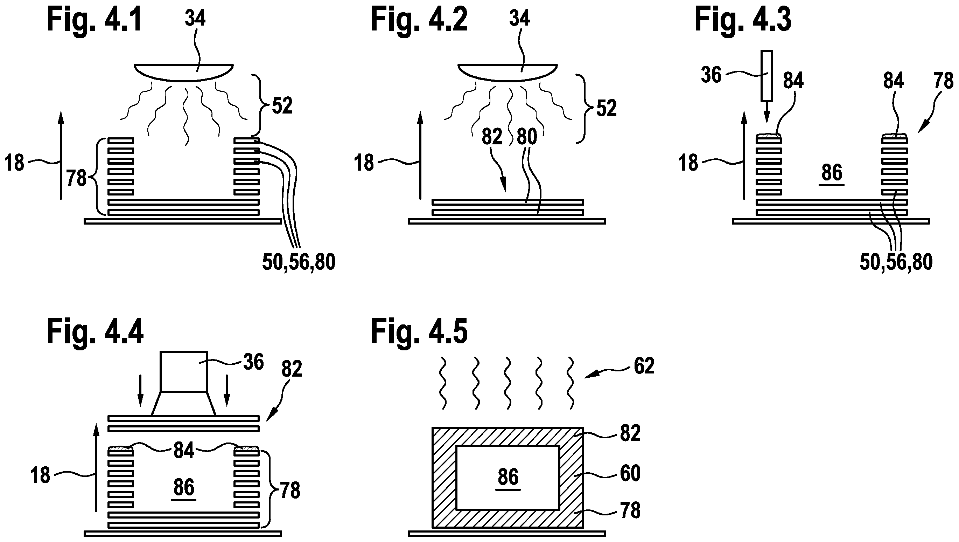

In der Darstellung gemäß den Figuren 4.1 bis 4.5 ist die Fertigung eines den Hohlraum 86 umschließenden Bauteils dargestellt, wobei dieses Bauteil ohne Stützstruktur auskommt.

Figur 4.1 zeigt ein erstes geschichtetes Objekt 78 aus einer Anzahl von Einzelschichten 80, die entweder als offene 2D-Struktur 50 oder als verfüllte, also geschlossene 2D-Struktur 56 ausgeführt sind. Die Einzelschichten 80 sind in Richtung der Z-Achse 18 übereinandergeschichtet und bilden einen Stapelaufbau 58. Das erste geschichtete Objekt 78 wird nun einer Vernetzung 52 über mindestens eine UV-Lichtquelle 34 unterzogen. Das erste geschichtete Objekt 78 entspricht einer "Box", das zweite geschichtete Objekt 82 einem Deckel.

Figur 4.2 zeigt ein zweites geschichtetes Objekt 82, welches aus zwei Einzelschichten 80 gefertigt ist, die in Richtung der Z-Achse 18 übereinanderliegend angeordnet sind. Auch hier erfolgt eine Vernetzung 52 des zweiten geschichteten Objekts 82 mittels mindestens einer UV-Lichtquelle 34 wie in Figur 4.2 angedeutet.

In der Darstellung gemäß Figur 4.3 wird über eine nadelförmige Applikationsvorrichtung 42 Klebstoff auf die beiden Schenkel einer "Box", also des ersten geschichteten Objekts 78 aufgetragen, welches zur Verbindung der beiden Objekte 78, 82 dient. In vorteilhafter Weise kann durch die erfindungsgemäß vorgeschlagene Lösung erreicht werden, dass für den Fall, dass das Fügemedium 84 ebenfalls ein kationisch polymerisierbares Epoxid ist, dieses mit dem oberen und unteren Teil in der finalen thermischen Aushärtung reagiert, wodurch die einzelnen Teile nicht nur stoffschlüssig verbunden, sondern auch chemisch miteinander vernetzt sind und somit ein homogenes Bauteil entsteht.

Aus Figur 4.4 geht hervor, dass auf diese mit dem Fügemedium 84 beschichteten Schenkel des ersten geschichteten Objektes 78 mittels des mindestens einen Vakuumgreifers 36 der Fertigungseinheit 12 das zweite geschichtete Objekt 82 aufgesetzt wird. Nach dem Aufsetzen des zweiten geschichteten Objektes 82 auf die mit dem Fügemedium 84 versehenen, sich parallel zueinander erstreckenden Schenkel des ersten geschichteten Objektes 78, erfolgt gemäß Figur 4.5 eine finale Vernetzung 62 auf thermischem Wege, so dass die beiden geschichteten Objekte 78, 82 miteinander gefügt werden und schlussendlich den Hohlraum 86 bilden. Entlang der Fügeflächen, die mit dem Fügemedium 84 versehen sind, entsteht eine chemische Vernetzung 76 zwischen den Einzelschichten 80 seien es 2D-Strukturen 50 in offener Form, seien es 2D-Strukturen 56, die verfüllt sind.

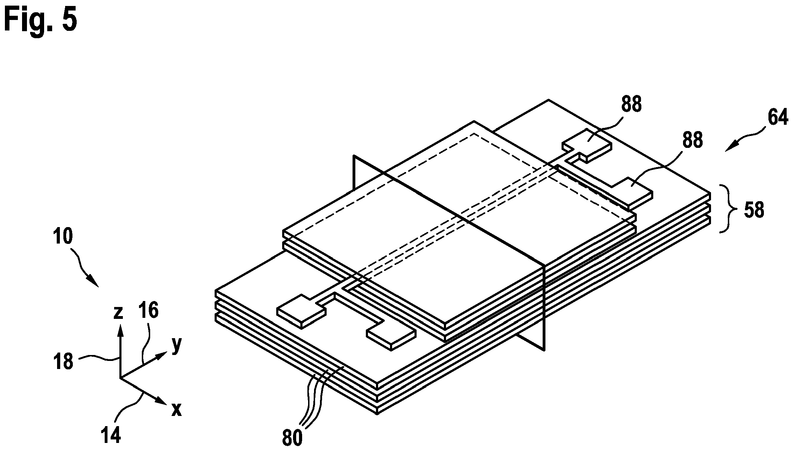

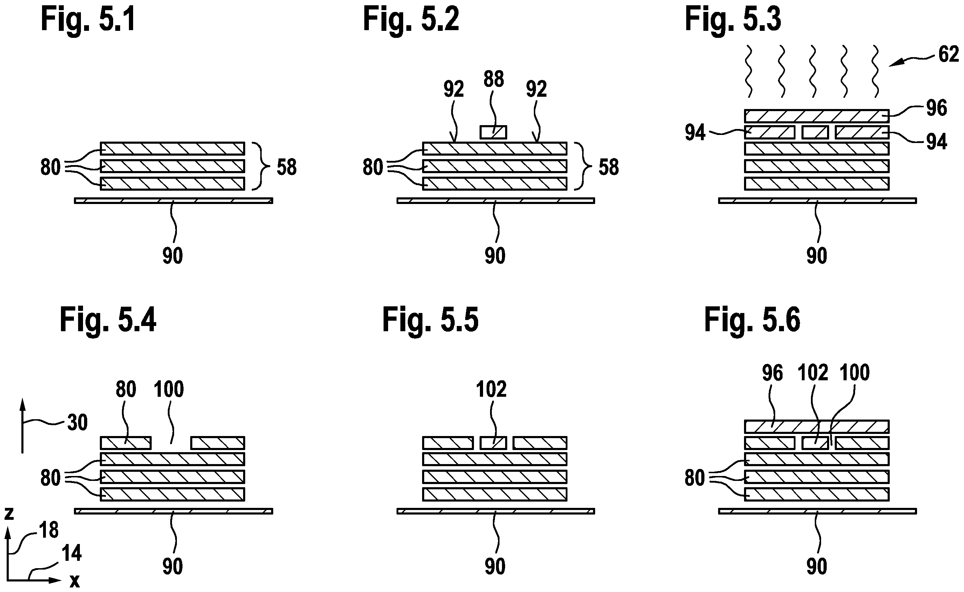

Figur 5 zeigt einen Schichtaufbau mit einer eingebetteten 2D-Leiterbahnstruktur 88.

Figur 5 ist das Koordinatensystem XYZ 10 zu entnehmen. Das vollständige elektronische Bauteil 64 ist als Stapelaufbau 58 aus einzelnen in Z-Richtung 30 übereinanderliegenden Einzelschichten 80 aufgebaut. Zwischen einzelnen Einzelschichten 80 des Stapelaufbaus ist eine 2D-Leiterbahnstruktur 88 integriert. Diese erstreckt sich im Wesentlichen in einer X-Y-Ebene auf einer Einzelschicht 80.

Der Figurensequenz 5.1 bis 5.3 ist eine erste Vorgehensweise zum Aufbau der 2D-Leiterbahnstruktur 88 gemäß Figur 5 zu entnehmen. Auf eine Bodenschicht 90 wird eine Anzahl von Einzelschichten 80 aus Aufbaumaterial 94 aufgebracht, so dass ein Stapelaufbau 58 entsteht. In Figur 5.2 ist dargestellt, dass auf eine Freifläche 92 auf der Oberseite einer Einzelschicht 80 ein Teil einer 2D-Leiterbahn 88, beispielsweise dargestellt durch einen Leitklebstoff 102 aufgebracht wird.

Figur 5.3 ist zu entnehmen, dass auf die Oberseite des Stapelaufbaus 58 gemäß Figur 5.2 neben dem Teil der 2D-Leiterbahn 88, d. h. auf den verbleibenden Teilen der Freifläche 92, weiteres Aufbaumaterial 94 aufgebracht wird; schlussendlich wird der Stapelaufbau 58 gemäß der Darstellung in Figur 5.3 durch eine Abdeckung 96 aus Aufbaumaterial 94 verschlossen; anschließend erfolgt eine finale Vernetzung 62 durch eine dementsprechende thermische Behandlung.

Alternativ kann die Erzeugung einer 2D-Leiterbahnstruktur 88 durch eine weitere Vorgehensweise gemäß der Figurensequenz 5.4 bis 5.6 durchgeführt werden.

Figur 5.4 zeigt eine Bodenschicht 90, auf der in Z-Richtung 30 Einzelschichten 80 aus Aufbaumaterial 94 aufgebracht werden. Eine der Einzelschichten 80 umfasst eine Kavität in Gestalt eines Kanals 100.

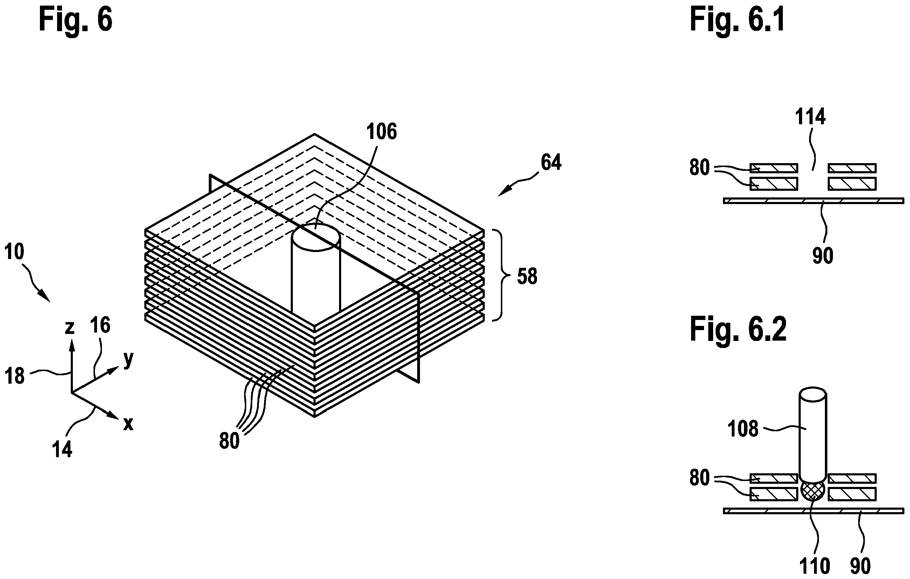

Figur 5.5 zeigt, dass in diese als Kanal beschaffene Kavität 100 ein Volumen eines Leitklebstoffes 102 eingebracht wird, was beispielsweise durch einen Dispenser 108, wie er in den Figuren 6.1 bis 6.7 schematisch dargestellt ist, erfolgen kann. Figur 5.6 ist zu entnehmen, dass auf die Einzelschicht 80, in deren als Kanal beschaffene Kavität 100 der Leitklebstoff 102 der 2D-Leiterbahnstruktur 88 eingebracht ist, eine Abdeckung 96 aus Aufbaumaterial 94 hinzugefügt wird, so dass der in Figur 5.6 dargestellte Stapelaufbau 58 entsteht.

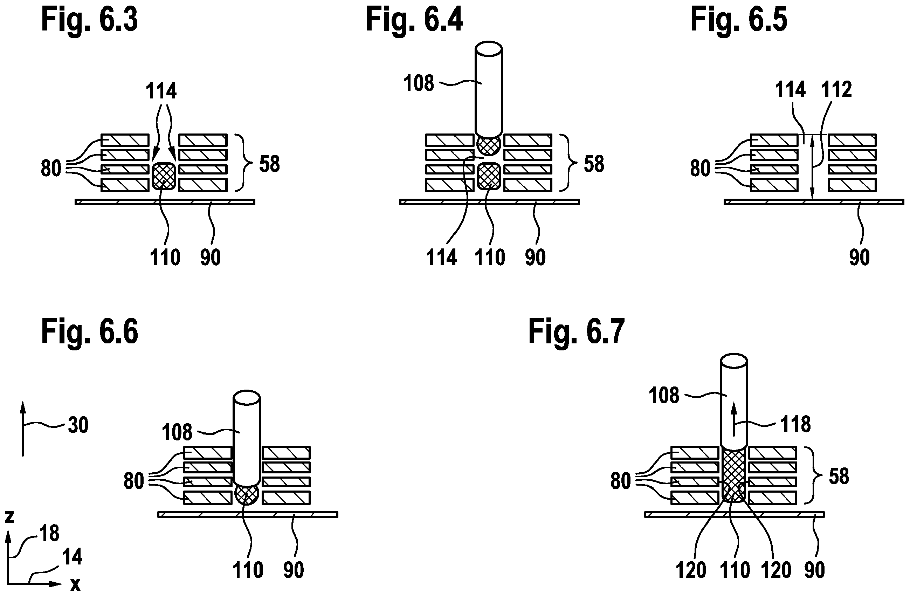

Figur 6 zeigt einen Schichtaufbau mit einer in diesen eingebetteten 3D-Leiterbahnstruktur 106.

Der Darstellung gemäß Figur 6 ist das vollständige elektronische Bauteil 64 zu entnehmen, welches entsprechend dem Koordinatensystem XYZ 10 aus mehreren Einzelschichten 80 entsprechend der Z-Achse 18 aufgebaut ist. Die Einzelschichten 80 aus Aufbaumaterial 94 sind in Z-Richtung 30 übereinanderliegend angeordnet und erstrecken sich in der Y-X-Ebene entsprechend dem Koordinatensystem XYZ 10 gemäß Figur 6. Mittig im vollständigen elektronischen Bauteil 64 erstreckt sich, im Wesentlichen in Richtung der Z-Achse 18, ein Teil einer 3D-Leiterbahnstruktur 106, die gemäß Figur 6 ein zylinderförmiges Aussehen hat.

Der Figurensequenz 6.1 bis 6.4 ist eine erste Vorgehensweise zum Aufbau der 3D-Leiterbahnstruktur 106 gemäß der Darstellung in Figur 6 zu entnehmen.

Gemäß Figur 6. 1 erfolgt zunächst ausgehend von der Bodenschicht 90 die Erzeugung von Einzelschichten 80 in Z-Richtung 30. In den übereinanderliegend angeordneten Einzelschichten 80 verläuft ein Kanal 114 in vertikaler Richtung. Der Kanal 114 befindet sich gemäß der Darstellung in Figur 6 ausgehend von der Bodenschicht 90 etwa mittig in den einzelnen übereinanderliegenden Einzelschichten 80 aus Aufbaumaterial 94.

Figur 6.2 zeigt ein Einfahren eines Dispensers 108 in den Kanal 114 in vertikaler Richtung beziehungsweise eine dementsprechende Kavität. Der Dispenser 108 beziehungsweise eine an diesem angeordnete Dispensernadel trägt ein Volumen 110 eines Leitklebstoffs 102 auf den Boden des Kanals 114 in vertikaler Richtung auf.

Gemäß der Figur 6.3 erfolgt ein weiterer Stapelaufbau 58 in Z-Richtung 30 aus übereinanderliegenden Einzelschichten 80 aus Aufbaumaterial 94. Dementsprechend erfolgt ein Aufbau des Kanals 114 in vertikaler Richtung. Figur 6.4 zeigt, dass auf das gemäß Figur 6.2 auf die Bodenschicht 90 aufgebrachte Volumen 110 ein weiteres Volumen von Leitklebstoff 102 mittels des Dispensers 108 aufgebracht wird, so dass entsprechend dem Anwachsen des Stapelaufbaus 58 in Z-Richtung 30 ein Aufbau der 3D-Leiterbahnstruktur 106 in Z-Richtung 30 aus dem Material des Leitklebstoffs 102 vorgenommen wird.

Der Figurensequenz 6.5 bis 6.7 ist eine andere Vorgehensweise zur Erzeugung einer 3D-Leiterbahnstruktur 106 zu entnehmen. Gemäß Figur 6.5 erfolgt in Z-Richtung 30 entlang der Z-Achse 18 ausgehend von der Bodenschicht 90 ein Aufbau von Einzelschichten 80, in welchen sich ein Kanal 114 in vertikaler Richtung entsprechend einer Kanalhöhe 112 erstreckt.

Der Kanal 114 in vertikaler Richtung, ausgeführt in Kanalhöhe 112, wird von vorvernetzten Kanalwänden 120 begrenzt.

Gemäß Figur 6.6 fährt der Dispenser 108 in den Kanal 114, der eine Kavität bildet, in vertikaler Richtung ein und bringt das Volumen 110 des Leitklebstoffs 102 am Boden des Kanals 114 in vertikaler Richtung auf.

Entsprechend einer vertikalen Ausfahrbewegung 118 des Dispensers 108 erfolgt ein weiteres Auftragen von Leitklebstoff 102 ausgehend vom Volumen 110 gemäß Figur 6.6 auf der Bodenschicht 90 entsprechend der Ausfahrbewegung 118 des Dispensers 108 aus dem Kanal 114 in vertikaler Richtung, bis der Dispenser 108 gerade die Kanalhöhe 112 passiert hat.

Die Vorgehensweise gemäß den Figuren 6.1 bis 6.4 unterscheidet sich von den Verfahrensschritten gemäß den Figuren 6.5 bis 6.7 dadurch, dass gemäß den

Figuren 6.1 bis 6.4 eine hier vertikal aus Volumina 110 von Leitklebstoff 102 aufgebaute Leiterbahn in mehreren Schritten schichtweise entsteht. Dabei wird der umgebende Kanal 114 in vertikaler Richtung durch Einzelschichten 80 in mehreren Schritten schichtweise gebaut und anschließend wieder aufgefüllt.

Bei der Vorgehensweise gemäß den Figuren 6.5 bis 6.7 wird der Kanal 114 in vertikaler Richtung in der vollständigen Kanalhöhe 112 zunächst aufgebaut und anschließend in einem Schritt mit Leitklebstoff 102 befüllt. Dabei fährt eine Dispensernadel des Dispensers 108 für Leitklebstoff 102 in einem Schritt sukzessive gemäß der Ausfahrbewegung 118 aus dem zuvor aufgebauten Kanal 114 in vertikaler Richtung aus. Hier wird die 3D-Leiterbahnstruktur 106 ausgehend von der Bodenschicht 90 von unten nach oben in vertikaler Richtung entsprechend der Ausfahrbewegung 118 kontinuierlich aufgebaut.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Verfahren zur Fertigung vollständiger elektronischer Bauteile (64) mit elektronischen und/oder nicht-elektronischen Komponenten (74), die in einem zeitgleich additiv aus 2D-Strukturen (50) in Z-Richtung (30) aufgebautem Gehäuse (60) integriert werden, mit nachfolgenden Verfahrensschritten:
a) Druck einer Außenkontur (48) einer 2D-Struktur (50),
b) Vernetzung 52 der Außenkontur (48) der 2D-Struktur (50),
c) mittels einer UV-Lichtquelle (34),
d) Auffüllung 54 der Außenkontur (48) derart, dass Einzelschichten (80) in gewünschter Geometrie mit Freisparungen für mindestens eine Kavität (70, 72, 100, 114) erzeugt werden,
e) erneute Vernetzung (52) der verfüllten 2D-Struktur (56) mittels der UV-Lichtquelle (34),
f) Erzeugung eines Stapelaufbaus (58) durch Wiederholung der Schritte a) bis e),
g) Einfüllen von Klebstoff in die mindestens eine Kavität (70, 72, 100, 114) in einer definierten Menge,
h₁) Platzierung mindestens einer elektronischen oder nicht-elektronischen Komponente (74) in die mindestens eine Kavität (70, 72, 100, 114) und Erzeugung einer geschlossenen Einzelschicht (80) mit eingebetteter Komponente (74) oder
h₂) Erzeugen von 2D-Leiterbahnstrukturen (88) oder 3D-Leiterbahnstrukturen (106) in Kavitäten (100, 114), insbesondere Kanälen, oder auf Freiflächen (92) durch Dispensen eines Leitklebstoffs (102) in die als Kanäle ausgeführten Kavitäten (100, 114) oder auf die Freiflächen (92),
i) Erneute Vernetzung (52) der geschlossenen 2D-Struktur (56),
j) Wiederholung der Verfahrensschritte a) bis e) solange, bis ein vollständiger Stapelaufbau (58) in Z-Richtung (30) aufgebaut ist und
k) Aushärtung des erhaltenen Stapelaufbaus (58) des vollständigen elektronischen Bauteils (64) aus 2D-Strukturen (50) in Z-Richtung (30).

2. Verfahren gemäß Anspruch 1, **dadurch gekennzeichnet, dass** in den Verfahrensschritten a) und d) ein bei Raumtemperatur verarbeitbares, höher viskoses Material zur Herstellung der 2D-Strukturen (50, 56) eingesetzt wird.

3. Verfahren gemäß den Ansprüchen 1 und 2, **dadurch gekennzeichnet, dass** in den Verfahrensschritten a) und d) kationisch polymerisierende 1K-Epoxide in Kombination mit extern stimulierbaren Initiatorsystemen verarbeitet werden.

4. Verfahren gemäß Anspruch 3, **dadurch gekennzeichnet, dass** kationisch polymerisierende 1K-Epoxide ausgewählt sind aus einer Gruppe, die umfasst:
Diglycdidyletherderivate von Bisphenol A (DGEBA), 3,4-Epoxycyclohexylmethyl-3,4-expoxycyclohexancarboxylate (ECC) und Epoxide von aliphatischen Alkoholen wie Trimethylolpropan.

5. Verfahren gemäß Anspruch 3, **dadurch gekennzeichnet, dass** die extern stimulierbaren Initiatorsysteme aus der Gruppe ausgewählt sind, insbesondere zu eisenbasierter Lewissäure zerfallende Ferroceniumsalze.

6. Verfahren gemäß einem der Ansprüche 1 bis 5, **dadurch gekennzeichnet, dass** als Aufbaumaterial (94) bevorzugt epoxidbasiertes Material eingesetzt wird.

7. Verfahren gemäß einem der Ansprüche 1 bis 6, **dadurch gekennzeichnet, dass** eine Vernetzung (52) über die UV-Lichtquelle (34) beim schichtweisen Auftrag der 2D-Strukturen (50) nach der Auffüllung (54) erfolgt.

8. Verfahren gemäß einem der Ansprüche 1 bis 6, **dadurch gekennzeichnet, dass** eine finale Vernetzung (62) der 2D-Strukturen (50, 56) innerhalb des Stapelaufbaus (58) auf thermischem Wege durchgeführt wird.

9. Verfahren gemäß den Ansprüchen 7 oder 8, **dadurch gekennzeichnet, dass** bei der Vernetzung (52) oder der finalen Vernetzung (62) chemische Reaktionen zwischen den 2D-Strukturen (50, 56) erfolgen, die die Festigkeit des Stapelaufbaus (58) in Z-Richtung (30) verbessern.

10. Verfahren gemäß den Ansprüchen 1 bis 9, **dadurch gekennzeichnet, dass** im Rahmen einer dualen Härtung mit Vernetzung (52) und finaler Vernetzung (62) Klebeprozesse in Bereichen erfolgen, die außerhalb des Strahlungsbereiches der UV-Lichtquelle (34) liegen.

11. Verfahren gemäß den Ansprüchen 1 bis 10, **dadurch gekennzeichnet, dass** Schichthöhen ab 0,08 mm aufgebaut werden, wobei eine maximale Schichthöhe von einer Tiefe vorangegangener Vernetzungen (52) abhängig ist.

12. Verfahren gemäß den Ansprüchen 1 bis 11, **dadurch gekennzeichnet, dass** der Verfahrensschritt h₂) mittels eines in horizontaler und in vertikaler Richtung verfahrbaren Dispensers (108) durchgeführt wird.

13. Verfahren gemäß den Ansprüchen 1 bis 12, **dadurch gekennzeichnet, dass** der Dispenser (108) innerhalb der als Kanal ausgeführten Kavität (114) entsprechend einer Kanalhöhe (112) wiederholt ein Volumen (110) von Leitklebstoff (102) dispenst.

14. Verwendung des Verfahrens gemäß einem der vorstehenden Ansprüche zur Fertigung von vollständigen elektronischen Bauteilen (64) mit integrierten elektrischen Funktionalitäten, wie beispielsweise mehrschichtigen Leiterplatten, elektrischen Steckverbindungen, 3D-Antennen, emissionsspezifischen Satellitenkomponenten, 3D-Strukturen mit integrierter Elektronik, Batterien oder bauteilintegrierten 2D-Leiterbahnstrukturen (88) oder bauteilintegrierten 3D-Leiterbahnstrukturen (106)

## Claims

1. Method for manufacturing complete electronic components (64) with electronic and/or non-electronic parts (74) which are integrated into a housing (60) that is simultaneously additively constructed in a Z direction (30) from 2D structures (50), comprising the following method steps:
a) printing an outer contour (48) of a 2D structure (50),
b) crosslinking (52) the outer contour (48) of the 2D structure (50)
c) by means of a UV light source (34),
d) filling (54) the space inside the outer contour (48) so as to produce individual layers (80) with a desired geometry with clearances for at least one cavity (70, 72, 100, 114),
e) re-crosslinking (52) the 2D structure (56), which is in a filled state, by means of the UV light source (34),
f) producing a stacked construction (58) by repeating the steps a) to e),
g) introducing a defined quantity of adhesive into the at least one cavity (70, 72, 100, 114),
h₁) placing at least one electronic or non-electronic part (74) into the at least one cavity (70, 72, 100, 114) and producing a closed individual layer (80) with embedded component (74), or
h₂) producing 2D conductor-track structures (88) or 3D conductor-track structures (106) in cavities (100, 114), in particular channels, or on free surfaces (92) by dispensing a conductive adhesive (102) into the cavities (100, 114), in the form of channels, or onto the free surfaces (92),
i) re-crosslinking (52) the 2D structure (56), which is in a closed state,
j) repeating the method steps a) to e) until construction of a complete stacked construction (58) in the Z direction (30), and
k) curing the obtained stacked construction (58) of the complete electronic component (64) composed of 2D structures (50) in the Z direction (30).

2. Method according to Claim 1, **characterized in that**, in the method steps a) and d), for producing the 2D structures (50, 56), use is made of a material of relatively high viscosity that is able to be processed at room temperature.

3. Method according to Claims 1 and 2, **characterized in that**, in the method steps a) and d), cationically polymerizing 1C epoxies are processed in combination with externally stimulatable initiator systems.

4. Method according to Claim 3, **characterized in that** cationically polymerizing 1C epoxies are selected from a group comprising:
diglycidyl ether derivatives of bisphenol A (DGEBA), 3,4-epoxycyclohexylmethyl-3,4-epoxycyclohexanecarboxylates (ECC) and epoxies of aliphatic alcohols such as trimethylolpropane.

5. Method according to Claim 3, **characterized in that** the externally stimulatable initiator systems are selected from the group of ferrocenium salts which break down in particular into iron-based Lewis acid.

6. Method according to one of Claims 1 to 5, **characterized in that**, as construction material (94), use is preferably made of epoxy-based material.

7. Method according to one of Claims 1 to 6, **characterized in that** a process of crosslinking (52) via the UV light source (34) takes place when the 2D structures (50) are applied layer-by-layer after the filling (54).

8. Method according to one of Claims 1 to 6, **characterized in that** a process of final crosslinking (62) of the 2D structures (50, 56) is carried out within the stacked construction (58) by thermal means.

9. Method according to Claim 7 or 8, **characterized in that**, during the crosslinking (52) or the final crosslinking (62), chemical reactions between the 2D structures (50, 56) that improve the strength of the stacked construction (58) in the Z direction (30) take place.

10. Method according to Claims 1 to 9, **characterized in that**, in the course of dual curing involving crosslinking (52) and final crosslinking (62), adhesive processes take place in regions which are situated outside the radiation range of the UV light source (34).

11. Method according to Claims 1 to 10, **characterized in that** layers having heights of 0.08 mm or greater are constructed, wherein a maximum layer height is dependent on a depth of previous processes of crosslinking (52).

12. Method according to Claims 1 to 11, **characterized in that** the method step h₂) is carried out by means of a dispenser (108) which is movable in a horizontal and in a vertical direction.

13. Method according to Claims 1 to 12, **characterized in that** the dispenser (108) repeatedly dispenses a volume (110) of conductive adhesive (102) within the cavity (114), which is in the form of a channel, according to a channel height (112).

14. Use of the method according to one of the preceding claims for manufacturing complete electronic components (64) with integrated electrical functionalities, such as for example multi-layer printed circuit boards, electrical plug connections, 3D antennas, emission-specific satellite parts, 3D structures with integrated electronics, batteries or component-integrated 2D conductor-track structures (88) or component-integrated 3D conductor-track structures (106).

## Revendications

1. Procédé de fabrication de composants électroniques complets (64) avec des éléments électroniques et/ou non électroniques (74), qui sont intégrés dans un boîtier (60) construit simultanément de manière additive à partir de structures 2D (50) dans la direction Z (30), avec les étapes de procédé suivantes :
a) l'impression d'un contour extérieur (48) d'une structure 2D (50),
b) la réticulation 52 du contour extérieur (48) de la structure 2D (50),
c) au moyen d'une source de lumière UV (34),
d) le remplissage 54 du contour extérieur (48) de manière à produire des couches individuelles (80) de géométrie souhaitée avec des évidements pour au moins une cavité (70, 72, 100, 114),
e) la nouvelle réticulation (52) de la structure 2D remplie (56) au moyen de la source de lumière UV (34),
f) la production d'une construction empilée (58) par répétition des étapes a) à e),
g) le remplissage d'adhésif dans l'au moins une cavité (70, 72, 100, 114) en une quantité définie,
h₁) la mise en place d'au moins un élément électronique ou non électronique (74) dans l'au moins une cavité (70, 72, 100, 114) et la production d'une couche individuelle fermée (80) avec l'élément (74) incorporé, ou
h₂) la production de structures de pistes conductrices 2D (88) ou de structures de pistes conductrices 3D (106) dans des cavités (100, 114), notamment des canaux, ou sur des surfaces libres (92) par distribution d'un adhésif conducteur (102) dans les cavités (100, 114) réalisées sous forme de canaux ou sur les surfaces libres (92), i) la nouvelle réticulation (52) de la structure 2D fermée (56),
j) la répétition des étapes de procédé a) à e) jusqu'à ce qu'une construction empilée complète (58) soit construite dans la direction Z (30), et
k) le durcissement de la construction empilée obtenue (58) du composant électronique complet (64) de structures 2D (50) dans la direction Z (30).

2. Procédé selon la revendication 1, **caractérisé en ce que**, dans les étapes de procédé a) et d), on utilise un matériau à viscosité plus élevée, pouvant être traité à température ambiante, pour la fabrication des structures 2D (50, 56).

3. Procédé selon les revendications 1 et 2, **caractérisé en ce que**, dans les étapes de procédé a) et d), on traite des époxydes monocomposants à polymérisation cationique en combinaison avec des systèmes d'initiateur stimulables de l'extérieur.

4. Procédé selon la revendication 3, **caractérisé en ce que** des époxydes monocomposants à polymérisation cationique sont choisis dans un groupe comprenant :
les dérivés d'éthers diglycidyliques de bisphénol A (DGEBA), les carboxylates de 3,4-époxycyclohexylméthyl-3,4-éxpoxycyclohexane(ECC) et les époxydes d'alcools aliphatiques comme le triméthylolpropane.

5. Procédé selon la revendication 3, **caractérisé en ce que** les systèmes d'initiateur stimulables de l'extérieur sont choisis dans le groupe, notamment des sels de ferrocénium se décomposant en acide de Lewis à base de fer.

6. Procédé selon l'une quelconque des revendications 1 à 5, **caractérisé en ce que** l'on utilise de préférence un matériau à base d'époxy comme matériau de construction (94) .

7. Procédé selon l'une quelconque des revendications 1 à 6, **caractérisé en ce qu'**une réticulation (52) est effectuée via la source de lumière UV (34) lors de l'application par couches des structures 2D (50) après le remplissage (54).

8. Procédé selon l'une quelconque des revendications 1 à 6, **caractérisé en ce qu'**une réticulation finale (62) des structures 2D (50, 56) est réalisée par voie thermique au sein de la construction empilée (58).

9. Procédé selon les revendications 7 ou 8, **caractérisé en ce que**, lors de la réticulation (52) ou de la réticulation finale (62), des réactions chimiques ont lieu entre les structures 2D (50, 56), qui améliorent la résistance de la construction empilée (58) dans la direction Z (30).

10. Procédé selon les revendications 1 à 9, **caractérisé en ce que**, dans le cadre d'un durcissement double avec réticulation (52) et réticulation finale (62), des processus de collage ont lieu dans des zones qui se situent en dehors de la zone de rayonnement de la source de lumière UV (34).

11. Procédé selon les revendications 1 à 10, **caractérisé en ce que** des hauteurs de couche à partir de 0,08 mm sont construites, une hauteur de couche maximale dépendant d'une profondeur de réticulations précédentes (52).

12. Procédé selon les revendications 1 à 11, **caractérisé en ce que** l'étape de procédé h₂) est réalisée au moyen d'un distributeur (108) pouvant être déplacé dans les directions horizontale et verticale.

13. Procédé selon les revendications 1 à 12, **caractérisé en ce que** le distributeur (108) distribue de manière répétée un volume (110) d'adhésif conducteur (102) à l'intérieur de la cavité (114) réalisée sous forme de canal correspondant à une hauteur de canal (112).

14. Utilisation du procédé selon l'une quelconque des revendications précédentes pour la fabrication de composants électroniques complets (64) avec des fonctionnalités électriques intégrées, tels que par exemple des cartes de circuits imprimés multicouches, des connecteurs électriques, des antennes 3D, des éléments satellites à émission spécifique, des structures 3D avec électronique intégrée, des batteries ou des structures de pistes conductrices 2D (88) intégrées au composant ou des structures de pistes conductrices 3D (106) intégrées au composant.
